# FASCICULE DE BREVET EUROPEEN

(11) **EP 4 422 062 B1**
(45) Date de publication et mention de la délivrance du brevet: **09.04.2025**
(21) Numéro de dépôt: 24153757.0
(22) Date de dépôt: 24.01.2024
(51) Int. Cl.: H02P 6/16, H02M 1/32, H02M 7/539

(54) **CONTRÔLEUR AMÉLIORÉ DE CIRCUIT D'ALIMENTATION ÉLECTRIQUE D'UN MOTEUR SUPRACONDUCTEUR, SYSTÈME D'ALIMENTATION ÉLECTRIQUE SUPRACONDUCTEUR D'UN MOTEUR, ET AÉRONEF COMPRENANT UN TEL SYSTÈME**
VERBESSERTE STEUERUNG FÜR DIE STROMVERSORGUNGSSCHALTUNG EINES SUPRALEITENDEN MOTORS, SUPRALEITENDES STROMVERSORGUNGSSYSTEM EINES MOTORS UND FLUGZEUG MIT SOLCH EINEM SYSTEM
IMPROVED CONTROLLER FOR POWER SUPPLY CIRCUIT OF A SUPERCONDUCTING MOTOR, SUPERCONDUCTING POWER SUPPLY SYSTEM OF A MOTOR, AND AIRCRAFT COMPRISING SUCH A SYSTEM

(30) Priorité: 22.02.2023 FR 2301614
(43) Date de publication de la demande: 28.08.2024
(73) Titulaire: Airbus (S.A.S.), 31700 Blagnac (FR)
(72) Inventeur: ROUQUETTE, Jean-François, TOULOUSE (FR); FALLOUH, Christian, TOULOUSE (FR)
(74) Mandataire: Airbus-OPS SAS

(56) Documents cités:
- WO-A1-2019/146269
- US-A1- 2005 258 795
- NOLAN STEVEN ET AL: "Voltage-Based Current-Compensation Converter Control for Power Electronic Interfaced Distribution Networks in Future Aircraft", IEEE TRANSACTIONS ON TRANSPORTATION ELECTRIFICATION, IEEE, vol. 6, no. 4, 29 May 2020 (2020-05-29), pages 1819 - 1829, XP011818657, DOI: 10.1109/TTE.2020.2998522

## Description

### DOMAINE TECHNIQUE

La présente invention concerne un moteur dit supraconducteur, notamment du type utilisable pour la propulsion d'un aéronef. L'invention concerne plus particulièrement la surveillance et le contrôle d'un lien d'alimentation supraconducteur de moteur électrique d'aéronef alimenté à partir d'un onduleur, et un aéronef.

### ÉTAT DE LA TECHNIQUE ANTÉRIEURE

L'industrie aéronautique opère de profonds changements en termes de conception des aéronefs, dans un but de réduction importante des émissions de dioxyde de carbone et des oxydes d'azote, en raison des contraintes en matière d'écologie et de développement durable.

L'utilisation d'hydrogène liquide comme source d'énergie pour un aéronef est une voie prometteuse pour ce faire. L'hydrogène peut être utilisé dans une pile à combustible, pour générer de l'électricité, ou directement comme carburant dans un groupe motopropulseur. De plus, des travaux sont spécifiquement orientés pour optimiser les systèmes de propulsion électrique ou hybride des aéronefs et l'hydrogène présent sous forme liquide à bord d'un aéronef peut être utilisé pour accroître la performance des équipements électriques en abaissant leur résistivité et en réduisant par conséquent les pertes par effets Joule. Il est également possible d'utiliser des composants supraconducteurs. Des conducteurs supraconducteurs peuvent être utilisés pour la distribution de courant alternatif dans des architectures comprenant des moteurs électriques alimentés par des convertisseurs électroniques de puissance contrôlés, tels que les onduleurs. Dans de telles architectures d'alimentation électrique d'un moteur, le lien supraconducteur entre l'onduleur et le moteur doit être protégé contre une transition inattendue de l'état supraconducteur à l'état conventionnel (transition usuellement nommée *quench* dans le domaine de la supraconduction). Il est donc important de pouvoir détecter des signes précurseurs d'une telle transition afin d'éviter un excès de pertes par effet Joule de nature à endommager les circuits électriques d'alimentation et leur environnement proche.

La détection du *quench* d'un conducteur supraconducteur est généralement opérée en surveillant la tension aux bornes de celui-ci et en détectant l'apparition d'une augmentation du niveau de tension à ses bornes Si la détection d'un *quench* sur une liaison porteuse d'un courant continu (liaison dite DC) est assez aisée puisqu'il s'agit de discriminer une impédance (i.e. résistance) nulle ou non nulle du conducteur, il n'en est pas de même pour une liaison porteuse d'un courant alternatif (liaison dite AC). En effet, dans ce dernier cas, la composante inductive de l'impédance n'est jamais nulle et est même supérieure à la composante résistive dans la plupart des cas, ce qui perturbe voire empêche une détection du *quench* avec des moyens habituels. Il existe donc un besoin d'obtenir une solution fiable permettant de s'affranchir de l'effet inductif sur la tension aux bornes du ou des conducteurs du lien d'alimentation électrique du moteur.

Le document "Voltage-Based Current-Compensation Converter Control for Power Electronic Interfaced Distribution Networks in Future Aircraft" de Steven Nolan, Catherine E. Jones, Rafael Peña-Alzola, Patrick J. Norman, Graeme Burt, Paul Miller et Mark Husband, divulgue un procédé de contrôle et de gestion de la puissance dans un réseau de distribution électrique selon l'art antérieur.

La situation peut être améliorée.

### EXPOSÉ DE L'INVENTION

Un objet de la présente invention est de proposer un contrôleur de circuit d'alimentation d'un moteur électrique alimenté en courant alternatif, apte à détecter de façon rapide et fiable l'apparition d'un phénomène de type *quench* dans un lien d'alimentation électrique vers un moteur, de sorte à limiter le ou les courants délivrés au moteur par un onduleur lorsque le lien d'alimentation entre l'onduleur et le moteur s'apprête à passer d'un état supraconducteur nominal à un état dans lequel sa résistivité croît.

A cet effet, il est proposé un procédé de contrôle d'un circuit d'alimentation d'un moteur électrique, le circuit d'alimentation comprenant un convertisseur de puissance, dit onduleur, configuré pour délivrer au moins une tension alternative à partir d'une source de tension continue et un lien d'alimentation supraconducteur configuré pour alimenter le moteur électrique, le lien d'alimentation supraconducteur étant connecté entre une sortie de l'onduleur et le moteur électrique, le procédé étant exécuté dans un contrôleur de circuit d'alimentation comprenant une sortie de contrôle configurée pour contrôler l'onduleur, au moins une première entrée configurée pour recevoir au moins un premier signal représentatif d'une tension mesurée aux bornes du lien d'alimentation supraconducteur, et une deuxième entrée, dite de synchronisation, configurée pour recevoir au moins un deuxième signal représentatif de la position du rotor du moteur électrique, le procédé comprenant :
- i) multiplier le premier signal et un signal sinusoïdal synchronisé avec le deuxième signal pour obtenir un troisième signal représentatif de la composante résistive de la tension mesurée aux bornes du lien d'alimentation supraconducteur, puis,
- ii) si le troisième signal excède une valeur seuil prédéterminée, inhiber la sortie de contrôle, et sinon, réitérer les étapes i) et ii).

Avantageusement, il est ainsi possible de détecter de façon fiable et rapide, et avec des moyens limités, l'apparition d'un phénomène de *quench* dans un lien d'alimentation supraconducteur d'un moteur électrique alimenté en courant alternatif.

Selon un mode de réalisation, dans le procédé de contrôle d'un circuit d'alimentation, obtenir ledit troisième signal comprend un filtrage passe-bas d'un résultat de multiplication dudit premier signal avec ledit deuxième signal.

L'invention a également pour objet un dispositif contrôleur de circuit d'alimentation d'un moteur électrique, le circuit d'alimentation comprenant un convertisseur de puissance, dit onduleur, configuré pour délivrer au moins une tension alternative à partir d'une source de tension continue et un lien d'alimentation supraconducteur configuré pour alimenter le moteur électrique, le lien d'alimentation supraconducteur étant connecté entre une sortie de l'onduleur et le moteur électrique, le dispositif contrôleur de circuit d'alimentation comprenant une sortie de contrôle configurée pour contrôler l'onduleur, au moins une première entrée configurée pour recevoir au moins un premier signal représentatif d'une tension mesurée aux bornes du lien d'alimentation supraconducteur, et une deuxième entrée, dite de synchronisation, configurée pour recevoir au moins un deuxième signal représentatif de la position d'un rotor du moteur électrique, le dispositif contrôleur de circuit d'alimentation comprenant de la circuiterie électronique configurée pour :
- i) multiplier le premier signal et un signal sinusoïdal synchronisé avec le deuxième signal pour obtenir un troisième signal représentatif de la composante résistive de la tension mesurée aux bornes du lien d'alimentation supraconducteur, puis,
- ii) si ledit troisième signal excède une valeur seuil, inhiber ladite sortie de contrôle, et sinon, réitérer les étapes i) et ii).

Le dispositif contrôleur selon l'invention peut également comporter les caractéristiques suivantes, considérées seules ou en combinaison :
- Le dispositif contrôleur de circuit d'alimentation comprend en outre un circuit de filtrage passe-bas d'un résultat de multiplication dudit premier signal avec ledit deuxième signal pour obtenir ledit troisième signal.
- Ladite circuiterie électronique du dispositif contrôleur de circuit d'alimentation comprend une unité de contrôle à microprocesseur configurée pour réaliser des opérations et des traitements à partir de signaux appliqués sur lesdites première et deuxième entrées dudit contrôleur.
- Le contrôleur de circuit d'alimentation comprend :
   ∘ un circuit multiplieur de signaux comprenant une sortie de multiplieur et deux entrées de multiplieur dont l'une, première desdites deux entrées de multiplieur, est connectée à ladite première entrée et l'autre, deuxième desdites deux entrées de multiplieur, est connectée à une sortie d'un générateur de signaux sinusoïdaux contrôlés,
   ∘ un circuit filtre passe-bas à fréquence de coupure contrôlée, comprenant une sortie de signal filtré et une entrée de signal à filtrer, laquelle entrée de signal à filtrer est connectée à la sortie de multiplieur du multiplieur de signaux, et une entrée de contrôle de fréquence de coupure, laquelle entrée de contrôle de fréquence de coupure est connectée à une sortie d'un module de détermination de fréquence,
   ∘ un circuit de commande comprenant une entrée connectée à la sortie de signal filtré du circuit filtre passe-bas, et une sortie de commande configurée pour valider ou inhiber la transmission d'un signal de commande transmissible vers ladite sortie de contrôle du contrôleur de circuit d'alimentation.
- Ledit module de détermination de fréquence du contrôleur de circuit d'alimentation est configuré pour déterminer une fréquence de rotation du moteur électrique à partir d'un signal électrique comprenant des impulsions, appliqué sur la deuxième entrée et le générateur de signaux sinusoïdaux contrôlés est configuré pour générer un signal sinusoïdal de fréquence déterminée synchronisé avec une position de référence du rotor du moteur électrique.
- La fréquence de coupure contrôlée du filtre passe-bas du contrôleur de circuit d'alimentation est déterminée grâce à la fréquence de rotation déterminée.

L'invention a également pour objet un système d'alimentation électrique d'un moteur électrique comprenant un contrôleur de lien d'alimentation supraconducteur tel que décrit précédemment.

L'invention concerne de plus un aéronef comprenant au moins un contrôleur de lien d'alimentation supraconducteur tel que précédemment décrit ou un système tel que précité.

Enfin l'invention concerne un produit programme d'ordinateur comprenant des instructions de codes de programme pour exécuter les étapes du procédé décrit lorsque le programme est exécuté par un processeur d'un contrôleur de circuit d'alimentation, ainsi qu'un dispositif support de stockage comprenant un tel programme.

### BRÈVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints :
Fig. 1 illustre schématiquement un contrôleur de circuit d'alimentation électrique d'un moteur électrique opérant dans un système d'alimentation électrique d'un moteur d'aéronef, selon un mode de réalisation ;
Fig. 2 est un ordinogramme illustrant un procédé de contrôle d'un circuit d'alimentation électrique d'un moteur électrique, exécuté dans un contrôleur d'un système d'alimentation électrique d'un moteur d'aéronef, selon un mode de réalisation ;
Fig. 3 illustre schématiquement un contrôleur de circuit d'alimentation électrique d'un moteur électrique dans un système d'alimentation électrique d'un moteur d'aéronef, selon un mode de réalisation comprenant notamment l'utilisation de fonctions logicielles ;
Fig. 4 illustre schématiquement un contrôleur de circuit d'alimentation électrique d'un moteur électrique dans un système d'alimentation électrique d'un moteur d'aéronef, selon un mode de réalisation comprenant notamment des circuits et modules matériels ;
Fig. 5 illustre schématiquement un exemple d'architecture interne du contrôleur de circuit d'alimentation déjà représenté sur les Fig. 1 et Fig. 3 ; et,
Fig. 6 illustre un aéronef comprenant un système d'alimentation électrique comprenant un contrôleur de circuit d'alimentation électrique selon un mode de réalisation.

### EXPOSÉ DÉTAILLÉ DE MODES DE RÉALISATION

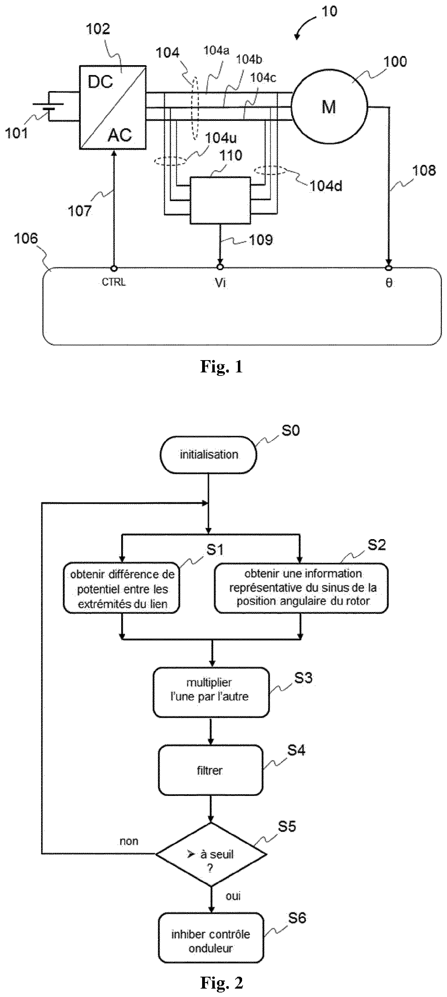

La **Fig. 1** est une représentation schématique d'un système d'alimentation électrique 10 configuré pour alimenter électriquement un moteur électrique 100, selon un mode de réalisation. Selon l'exemple décrit ici, le moteur électrique 100 est un moteur d'aéronef. Pour ce faire, le système d'alimentation électrique 10 comprend un contrôleur 106 de circuit d'alimentation pour contrôler un circuit d'alimentation comprenant un onduleur 102 alimentant lui-même un lien d'alimentation électrique supraconducteur 104 connecté au moteur électrique 100. Le lien d'alimentation électrique supraconducteur 104 est connecté entre une sortie de l'onduleur 102 et le moteur électrique 100. L'onduleur 102 opère des fonctions de convertisseur de puissance et fournit un réseau électrique triphasé de tensions au moteur électrique 100, via le lien d'alimentation supraconducteur 104, à partir d'une source de tension continue 101. Le réseau électrique triphasé comprend une première ligne d'alimentation électrique 104a, une deuxième ligne d'alimentation électrique 104b et une troisième ligne d'alimentation électrique 104c. Ces trois lignes d'alimentation électrique composent conjointement le lien d'alimentation supraconducteur 104.

Afin de contrôler le circuit d'alimentation du moteur électrique 100, le contrôleur 106 de circuit d'alimentation comprend au moins :
- une sortie CTRL de contrôle de courant configurée pour contrôler en courant l'onduleur 102,
- une première entrée, Vi, configurée pour recevoir un signal représentatif d'une tension mesurée aux bornes du lien d'alimentation supraconducteur 104, et,
- une deuxième entrée, θ, dite broche d'entrée de synchronisation, configurée pour recevoir au moins une information représentative de la position du rotor du moteur électrique 100, depuis le moteur électrique 100, via un lien de connexion 108.

Le contrôle de l'onduleur 102 par le contrôleur 106 de circuit d'alimentation utilise un lien de connexion 107. Selon un mode de réalisation, le lien de connexion 107 porte un signal de type modulation de largeur d'impulsion (du sigle PWM, et qui signifie « Pulse Width Modulation » en anglais) généré par des circuits et modules de commande opérant une commande de l'onduleur de type commande vectorielle.

Selon un mode de réalisation, les trois lignes d'alimentation 104a, 104b et 104c du lien d'alimentation supraconducteur 104 sont agencées dans un même volume cryogénique et l'une seulement d'entre elles fait l'objet d'une mesure de tension entre ses extrémités, par un module de détermination de différence de potentiel 110 dont une sortie est connectée à l'entrée Vi du contrôleur 106 de circuit d'alimentation via un lien de connexion 109. Selon cette configuration, et dans le cas d'une perte de fluide cryogénique entraînant un accroissement de la température dans le lien d'alimentation supraconducteur 104, la seule détection d'accroissement de la différence de potentiel sur la ligne d'alimentation connectée au module de détermination de différence de potentiel 110 suffit à opérer une détection de *quench* et à définir des opérations subséquentes utiles à la préservation des systèmes.

Selon une variante de réalisation, le module de détermination de différence de potentiel 110 comprend des circuits de multiplexage internes pour opérer une scrutation (surveillance) séquentielle des différences de potentiel entre les deux extrémités de chacune des lignes d'alimentation électrique 104a, 104b et 104c, successivement et de façon itérative.

Selon une variante de réalisation, chacune des lignes d'alimentation électrique 104a, 104b et 104c est associée à un module de détermination de différence de potentiel tel que le module 110 et les circuits de contrôle et de supervision décrits ci-après sont reproduits pour chacune des lignes d'alimentation 104a, 104b et 104c de sorte à détecter un phénomène de *quench* dans les plus brefs délais sur l'une ou l'autre des lignes d'alimentation 104a, 104b et 104c du lien d'alimentation électrique 104. Une logique de type « OU » est alors utilisée en sortie de ces trois circuits identiques ou similaires pour opérer une inhibition ou modification de la commande de l'onduleur en présence d'un phénomène *quench* sur l'une quelconque des trois lignes d'alimentation 104a, 104b et 104c du lien d'alimentation électrique supraconducteur 104. Les liens de connexion entre l'une des extrémités respectives des lignes d'alimentation électriques 104a, 104b et 104c et le module de détermination d'une différence de potentiel 110 forment un bus 104u. Les liens de connexion entre l'autre des extrémités respectives des lignes d'alimentation électriques 104a, 104b et 104c et le module de détermination d'une différence de potentiel 110 forment un bus 104d.

Astucieusement et avantageusement, le contrôleur 106 de circuit d'alimentation opère des traitements et opérations à partir d'une information de différence de potentiel mesurée aux bornes de l'une au moins des lignes d'alimentation électrique 104a, 104b et 104c, via le module de détermination d'une différence de potentiel 110 et son entrée Vi, d'une part, ainsi qu'à partir de la position du rotor du moteur électrique 100, obtenue via son entrée θ, pour discriminer la composante résistive de la tension mesurée aux bornes de l'une au moins des lignes d'alimentation du lien d'alimentation 104, d'autre part. Pour ce faire, le contrôleur 106 de circuit d'alimentation comprend de la circuiterie électronique configurée pour :
- i) multiplier le signal disponible sur l'entrée Vi avec un signal sinusoïdal synchronisé avec ledit signal disponible sur l'entrée θ pour obtenir un signal résultant de la multiplication, représentatif de la composante résistive de la tension mesurée aux bornes du lien d'alimentation supraconducteur 104, et,
de la circuiterie électronique configurée pour :
- ii) si le signal résultant de la multiplication excède une valeur seuil prédéterminée, inhiber la sortie CTRL de contrôle de l'onduleur 102 et sinon, réitérer en boucle les étapes i) et ii).

Selon un mode de réalisation, la circuiterie électronique est configurée pour inhiber la sortie CTRL de contrôle (commande) de l'onduleur 102 seulement si le signal résultant de la multiplication opérée excède la valeur seuil prédéterminée pendant au moins une durée seuil prédéterminée ou pendant une durée excédant cette durée seuil.

Les termes « inhiber la sortie de contrôle de l'onduleur » désignent ici toute opération subséquente à la détection du franchissement de la valeur seuil (le cas échéant pendant une durée égale à ou excédant une durée seuil) et visant à limiter la dissipation thermique par effet Joule dans le lien d'alimentation supraconducteur 104, en limitant le courant délivré par l'onduleur 102 dans chacune des lignes d'alimentation électriques 104a, 104b et 104c ou en interrompant le fonctionnement de l'onduleur 102.

Selon un exemple de réalisation, l'inhibition de la sortie CTRL définit un mode de fonctionnement dégradé de l'onduleur 102, à puissance réduite. Selon un autre exemple de réalisation, l'inhibition de la sortie CTRL isole la source de tension continue 101 de l'onduleur 102. Ces exemples de réalisation ne sont pas limitatifs et d'autres modes de contrôle de la puissance dissipée dans le lien d'alimentation électrique 104, via la sortie de contrôle CTRL du contrôleur 102 peuvent bien sûr être implémentés.

La **Fig. 2** est un diagramme de type ordinogramme qui illustre des étapes d'un procédé de contrôle du lien d'alimentation 104 du système d'alimentation électrique 10 du moteur électrique 100, exécuté par le contrôleur 106 de circuit d'alimentation, selon un mode de réalisation. Une étape **S0** comprend des opérations d'initialisation et de configuration de l'ensemble de systèmes en présence visant à obtenir un état nominal défini comme une configuration normalement opérationnelle pour une utilisation du moteur électrique 100 et de son circuit d'alimentation électrique 10.

Une étape **S1** comprend une obtention, par le contrôleur 106 de circuit d'alimentation, via son entrée Vi, d'une différence de potentiel mesurée entre les extrémités d'au moins une ligne d'alimentation électrique parmi les lignes d'alimentation électrique 104a, 104b et 104c du lien d'alimentation électrique supraconducteur 104. Une étape **S2** comprend une obtention, par le contrôleur 106 de circuit d'alimentation, d'une position du rotor du moteur 100, via son entrée θ, ainsi qu'une synchronisation d'un signal sinusoïdal construit de façon interne au contrôleur 106 de circuit d'alimentation avec une position θ1 prédéterminée du rotor, de sorte à isoler la composante purement résistive de la tension mesurée aux bornes d'une ou plusieurs lignes d'alimentation électrique du lien d'alimentation électrique 104 (synchronisée avec la composante fondamentale du courant injecté dans le moteur électrique 100) et à s'affranchir de toute perturbation en lien avec la composante inductive de cette tension. Plus précisément, l'étape S2 permet l'obtention d'une information sur le sinus de la position angulaire du rotor du moteur 100. Les étapes S1 et S2 sont réalisées en parallèle l'une de l'autre, c'est-à-dire simultanément. Astucieusement, les deux grandeurs ainsi obtenues, à savoir une première information représentative d'une différence de potentiel mesurée entre les extrémités du lien d'alimentation 104 et une deuxième information représentative du sinus de la position angulaire du rotor du moteur 100, sont multipliées lors d'une étape **S3** de sorte à opérer une détection améliorée d'un phénomène de *quench* adaptée à une alimentation triphasée en courant alternatif du moteur électrique 100.

Une étape optionnelle **S4** de filtrage passe-bas peut être réalisée pour filtrer le résultat de la multiplication opérée puis une comparaison du résultat de la multiplication, ou le cas échéant de ce résultat filtré par un filtre basse bas est comparé à une valeur seuil prédéterminée, lors d'une étape **S5.** Le résultat de l'étape S4 permet d'obtenir la composante résistive du lien d'alimentation 104. Une telle opération de filtrage passe-bas est toutefois optionnelle. Dans le cas où la valeur comparée avec la valeur seuil excède la valeur seuil prédéterminée, et donc en présence d'un phénomène de *quench,* la sortie de contrôle CTRL de l'onduleur 102 est inhibée lors d'une étape **S6** de sorte à préserver l'intégrité des systèmes d'alimentation du moteur électrique 100 en présence. Dans le cas contraire, et donc en l'absence de phénomène de *quench* détecté dans le lien d'alimentation électrique supraconducteur 104, le contrôleur 106 de circuit d'alimentation reboucle aux étapes S1 et S2 pour opérer une nouvelle itération des étapes du procédé décrites ci-avant. De façon optionnelle, lors de l'étape S5, et après détection d'un dépassement de la valeur seuil prédéterminée, il est vérifié que le dépassement de la valeur seuil prédéterminée est détecté pendant au moins une durée prédéterminée pour autoriser les opérations d'inhibition de l'étape S6, à défaut, si le dépassement de la valeur seuil prédéterminée ne survient que pendant un temps inférieur à la durée seuil prédéterminée puis est résorbé, le procédé continue en séquence en rebouclant à partir des étapes S1 et S2. Selon un mode de réalisation, une telle détection, ponctuelle, entraîne une configuration de systèmes de supervision et de contrôle du circuit d'alimentation électrique 10 du moteur 100.

Selon un mode de réalisation, la valeur seuil prédéterminée auquel est comparé le résultat de la multiplication réalisée à l'étape S3 est prédéterminée par calcul ou lors de tests opérationnels en laboratoire de recherche, ou encore lors de test de validation et/ou d'homologation. Il en est de même pour la valeur de la durée seuil de dépassement, le cas échéant. Selon un mode de réalisation, ces deux valeurs sont programmables, préférentiellement à distance via une interface de contrôle à distance du contrôleur 106 de circuit d'alimentation.

Les étapes du procédé décrit ci-avant peuvent être implémentées indifféremment par une circuiterie matérielle, par des fonctions logicielles ou par une combinaison de ces deux formes d'implémentation.

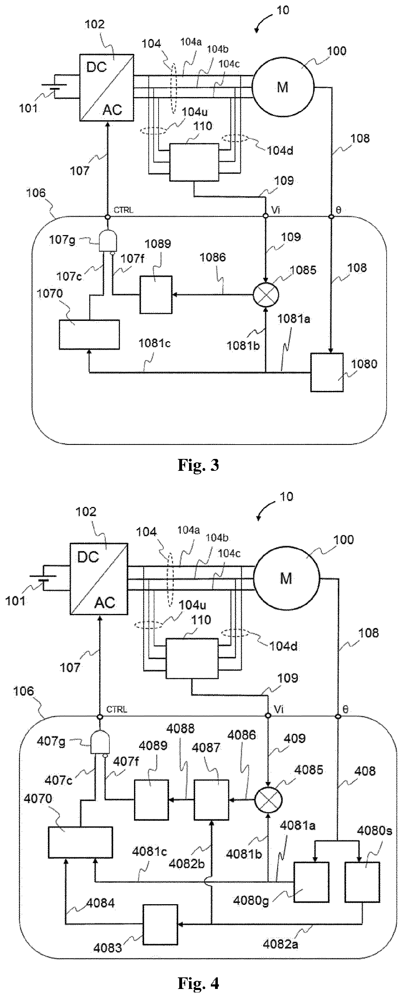

La **Fig. 3** représente des modules principaux du contrôleur 106 de circuit d'alimentation, implémentés sous forme matérielle ou logicielle ou une combinaison de ces deux formes. L'entrée Vi du contrôleur 106 de circuit d'alimentation est configurée pour recevoir une information représentative de la différence de potentiel présente entre des extrémités opposées des lignes d'alimentation 104a, 104b et 104c, via le lien de connexion 109. Les liaisons triphasées 104u et 104d de mesure de potentiel électrique relient respectivement les extrémités amont et aval du lien d'alimentation électrique supraconducteur 104 au module de détermination de différence de potentiel 110. Le module de détermination de différence de potentiel 110 comprend des moyens de multiplexage synchronisés pour connecter les différentes lignes d'alimentation de la liaison 104u et de la liaison 104d à ses circuits internes de détermination d'une différence de potentiel. Le module de détermination de différence de potentiel 110 est configuré en outre pour délivrer, via le lien de connexion 109, une information, sous la forme d'un signal, laquelle information est représentative des différences de potentiel présentes entre les extrémités (ou bornes) de chacune des lignes d'alimentation 104a, 104b ou 104c du lien d'alimentation électrique supraconducteur 104. Le module de détermination de différence de potentiel 110 peut comprendre une circuiterie électronique numérique, analogique ou encore une combinaison de ces deux types de circuiterie électronique pour opérer ces fonctions de détermination des tensions aux bornes du lien électrique supraconducteur 104, ou plus précisément d'une grandeur représentative de l'impédance d'une ou de plusieurs lignes d'alimentation du lien d'alimentation électrique supraconducteur 104.

Selon un mode de réalisation, l'entrée de synchronisation θ est reliée à une sortie de synchronisation en position du moteur électrique 100, via un lien de connexion 108, et porte un signal représentatif à la fois de la fréquence de rotation du moteur et de la position du rotor par rapport à une position de référence prédéfinie du rotor. Selon un mode de réalisation, le lien de connexion 108 comprend plusieurs signaux indépendants permettant de coder ces informations.

La sortie CTRL de contrôle du contrôleur 106 de circuit d'alimentation délivre, via le lien de connexion 107, des signaux modulés par modulation de largeur d'impulsions à une entrée de contrôle de commutation de l'onduleur 102. Selon l'exemple décrit, la sortie de l'onduleur 102 est contrôlée en courant à partir de la sortie CTRL de contrôle du contrôleur 106.

Selon un mode de réalisation, le contrôleur 106 de circuit d'alimentation comprend trois sorties CTRL1, CTRL2 et CTRL 3 dédiées chacune à l'une des lignes d'alimentation (phase) du lien d'alimentation électrique supraconducteur 104, triphasé et un système complet de détection de phénomène de *quench* est implémenté pour chacune des lignes d'alimentation 104a, 104b, et 104c du lien d'alimentation supraconducteur 104, dans le contrôleur 106 de circuit d'alimentation.

Dans la présente description, on nomme indifféremment un lien de connexion et le signal porté par ce lien de connexion. Ainsi, par exemple, le signal de synchronisation représentatif de la position du rotor du moteur électrique 100, porté par le lien de connexion 108, est appelé en outre le signal 108. De la même façon, le signal représentatif d'une différence de potentiel électrique délivré par le module 110, et porté par le lien de connexion 109, est appelé en outre le signal 109, et le signal de contrôle de courant, porté par le lien de connexion 107, est appelé en outre le signal 107.

Le principe de détection d'un phénomène de *quench* est décrit ici en relation avec le lien d'alimentation supraconducteur 104a. Selon un mode de réalisation, le même principe est appliqué pour les liens supraconducteurs d'alimentation 104b et 104c, en utilisant des moyens similaires à ceux implémentés pour ce qui concerne le lien d'alimentation supraconducteur 104a. S'agissant de la circuiterie électronique interne du contrôleur 106 de circuit d'alimentation, composé de l'onduleur 102 et du lien d'alimentation 104, le signal 108 de synchronisation délivré par la sortie de synchronisation du moteur électrique 100 est appliqué à un module 1080 de détermination de fréquence de rotation de moteur et de génération de signaux sinusoïdaux, encore appelé module 1080 de détermination de fréquence et de génération de signaux sinusoïdaux. Le module 1080 est notamment configuré pour générer des signaux sinusoïdaux contrôlés et synchronisés avec une position du rotor du moteur électrique 100. Des signaux synchronisés avec une position de référence angulaire du rotor sont délivrés via un lien de connexion 1081a. Astucieusement, un signal sinusoïdal synchronisé 1081a, est appliqué via un lien de connexion 1081b, sur une entrée d'un circuit multiplieur 1085 dont l'autre entrée est connectée au signal 109 représentatif de la différence de potentiel présente entre les extrémités de la ligne d'alimentation 104a ou d'une autre des lignes d'alimentation, le cas échéant. La multiplication de ce signal sinusoïdal synchronisé avec la composante résistive et d'une grandeur proportionnelle à une différence de potentiel mesurée entre les extrémités de la ligne d'alimentation supraconducteur 104a permet avantageusement de disposer, sur une sortie 1086 du multiplieur 1085, d'une information représentative de l'absence ou de la présence d'un phénomène de *quench* dans le lien supraconducteur 104. Cette information, présente sous la forme d'un signal contenant une composante continue d'intérêt et une composante présentant une fréquence égale à deux fois la fréquence des grandeurs en présence dans le lien 104, est ensuite optionnellement filtrée par un circuit filtre passe-bas (non représenté sur la Fig. 3) à fréquence de coupure contrôlée pour obtenir une information, d'une qualité encore meilleure, représentative de l'absence ou de la présence d'un phénomène de *quench* dans le lien supraconducteur 104. Le signal 1086, éventuellement filtré par un circuit filtre passe-bas, est ensuite appliqué à un circuit de commande 1089 configuré pour inhiber la sortie CTRL de contrôle de courant de l'onduleur 102 en présence d'un problème tel que par exemple un phénomène de *quench.* Le circuit de commande 1089 est configuré pour détecter un phénomène de *quench,* tel que cela est précédemment décrit, et peut être configuré en outre pour détecter un problème de température ou encore un problème de courant, par exemple. Plus largement, le circuit de commande 1089 est configuré pour opérer des fonctions de supervision et de protection du circuit d'alimentation électrique supraconducteur 10. En effet, selon un mode de réalisation, un signal disponible sur une sortie 107f du circuit de commande 1089 est appliqué à une sortie de commande (ou sortie commandée) configurée pour valider ou inhiber la transmission d'un signal de commande 107c transmissible vers la broche de sortie CTRL du contrôleur 106 de circuit d'alimentation, via un circuit de contrôle de sortie 107g. Ainsi, le signal de commande 107c transmissible vers la broche de sortie CTRL est déterminé à titre d'exemple par une commande de type commande vectorielle principalement implémentée par un module de commande 1070. Selon l'exemple de réalisation décrit ici, le signal 107 est donc identique au signal 107c lorsque le circuit de contrôle de sortie n'est pas activé par le circuit de commande 1089 pour inhiber la commande en courant de l'onduleur 102. Le module de commande 1070 est configuré pour opérer un contrôle du couple moteur et pour déterminer un signal de commande CTRL à partir notamment d'un signal 1081c qui correspond à une consigne de couple. Ce signal est en outre dépendant de la position angulaire θ du moteur électrique 100. Les détails d'implémentation de la commande vectorielle opérée par le contrôleur 106 de circuit d'alimentation, indépendants des circuits propres à la détection de *quench* décrits précédemment, ne sont pas décrits ici plus précisément dans la mesure où ils sont connus de l'homme du métier de la commande d'onduleur et dans la mesure où ils ne sont pas utiles à la bonne compréhension de l'invention.

L'utilisation astucieuse d'un circuit multiplieur tel que le circuit multiplieur 1085 pour obtenir une information représentative d'un phénomène de *quench* à partir de la différence de potentiel mesurée entre les extrémités du lien d'alimentation électrique supraconducteur 104 d'une part, et de la position angulaire θ du rotor du moteur électrique 100 d'autre part, permet donc d'opérer avantageusement une détection rapide et fiable de l'apparition d'un phénomène de *quench,* qui peut être d'autant plus fiable que le signal obtenu en sortie du circuit multiplieur 1085 peut être filtré par un circuit filtre passe-bas dont la fréquence de coupure dépend de la fréquence de rotation du moteur électrique 100. Avantageusement, la fréquence de coupure du filtre passe-bas utilisé est déterminée en fonction de la fréquence de rotation du moteur électrique 100.

L'utilisation d'un contrôleur de circuit d'alimentation présentant l'architecture interne du contrôleur 106 de circuit d'alimentation, ou une architecture équivalente opérant les mêmes fonctions, permet avantageusement de contrôler l'alimentation en énergie électrique du moteur 100 pour éviter une dégradation voire une destruction du lien supraconducteur 104 lorsque les conditions d'un bon fonctionnement ne sont plus réunies.

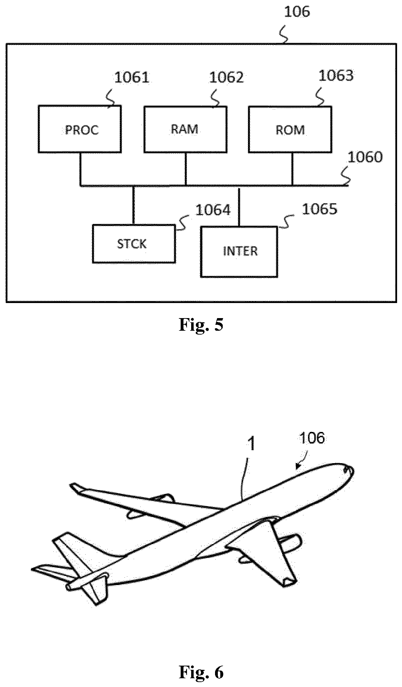

La **Fig. 5** est un diagramme illustrant un exemple d'architecture interne du contrôleur 106 de circuit d'alimentation, selon un mode de réalisation. Considérons à titre illustratif que la Fig. 5 illustre un agencement interne du contrôleur 106 de circuit d'alimentation. On note que la Fig. 5 pourrait aussi illustrer schématiquement un exemple d'architecture matérielle d'un module de traitement compris dans le contrôleur 106 de circuit d'alimentation, outre d'autres modules configurés pour opérer d'autres fonctions.

Selon l'exemple d'architecture matérielle représenté à la Fig. 5, le contrôleur 106 de circuit d'alimentation comprend alors, reliés par un bus de communication 1060 : un processeur ou CPU (« Central Processing Unit » en anglais) 1061 ; une mémoire vive RAM (« Random Access Memory » en anglais) 1062 ; une mémoire morte ROM (« Read Only Memory » en anglais) 1063 ; une unité de stockage telle qu'un disque dur (ou un lecteur de support de stockage, tel qu'un lecteur de cartes SD (« Secure Digital » en anglais) 1064 ; au moins un module d'interfaces 1065 permettant au contrôleur 106 de système d'alimentation de communiquer avec des dispositifs présents dans système d'alimentation 10, tels que par exemple, l'onduleur 102, le module de détermination d'une différence de potentiel 110 et le moteur électrique 100. Avantageusement, le module d'interfaces INTER 1065 comprend notamment des ports d'entrée-sorties, des entrées de convertisseurs de type numérique/analogique et de convertisseurs de type analogique/numérique, des sorties contrôlées en modulation de largeur d'impulsion, et plus généralement tous types d'interfaces utiles à la gestion d'un système d'alimentation d'un moteur par une source de courant triphasée du type d'un onduleur opérant à partir d'une source d'énergie continue. En particulier, le module d'interfaces INTER 1065 du contrôleur 106 est configuré pour opérer notamment des fonctions de commande vectorielle d'un onduleur tel que l'onduleur 102.

Le processeur 1061 est capable d'exécuter des instructions chargées dans la RAM 1062 à partir de la ROM 1063, d'une mémoire externe (non représentée), d'un support de stockage (tel qu'une carte SD), ou d'un réseau de communication. Lorsque le contrôleur de circuit d'alimentation 106 est mis sous tension, le processeur 1061 est capable de lire depuis la RAM 1062 des instructions de code de programme et de les exécuter. Ces instructions forment un programme d'ordinateur causant la mise en œuvre, par le processeur 1061, de tout ou partie d'un procédé décrit en relation avec les Fig. 2, ou de tout ou partie des variantes décrites de ce procédé.

Tout ou partie du procédé décrit en relation avec la Fig. 2, ou ses variantes décrites peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais). En général, le contrôleur 106 de circuit d'alimentation comprend de la circuiterie électronique configurée pour mettre en œuvre les procédés décrits en relation avec le contrôleur 106 de circuit d'alimentation. Bien évidemment, le contrôleur 106 de circuit d'alimentation comprend en outre tous les éléments usuellement présents dans un système comprenant une unité de contrôle et ses périphériques, tels que, un circuit d'alimentation, un circuit de supervision d'alimentation, un ou plusieurs circuits d'horloge, un circuit de remise à zéro, des ports d'entrées-sorties connexes, des entrées d'interruptions, des drivers (ou pilotes) de bus, cette liste étant non exhaustive.

La **Fig. 4** illustre un autre exemple d'implémentation du contrôleur 106 de circuit d'alimentation. Selon ce mode de réalisation, les circuits électroniques internes au contrôleur 106 du circuit d'alimentation sont tous implémentés de façon matérielle. Le signal 108 de synchronisation délivré par la sortie de synchronisation du moteur électrique 100 est appliqué à un module 4080s de détermination de fréquence de rotation de moteur, encore appelé module 4080s de détermination de fréquence, via l'entrée θ et via un lien de connexion interne 408 connecté au lien de connexion 108. Le signal 408 de synchronisation est appliqué en outre à un module 4080g générateur de signaux sinusoïdaux contrôlés. Des signaux sinusoïdaux peuvent alors être générés de façon synchronisée avec la position angulaire θ du rotor du moteur électrique 100. Astucieusement, un signal sinusoïdal synchronisé 4081a, est appliqué via un lien de connexion 4081b, sur une entrée d'un circuit multiplieur 4085 dont l'autre entrée est connectée au signal 409, relié au lien de connexion externe 109 via l'entrée Vi, et représentatif de la différence de potentiel présente entre des extrémités du lien d'alimentation supraconducteur 104a, ou encore, par multiplexage, de la ligne d'alimentation 104b ou de la ligne d'alimentation 104c. Là encore, la multiplication d'un signal sinusoïdal synchronisé avec la composante résistive de la tension aux bornes du lien d'alimentation, et d'une grandeur proportionnelle à une différence de potentiel mesurée entre les extrémités de la ligne d'alimentation supraconducteur 104a, permet de disposer, sur une sortie 4086 du multiplieur 4085, d'une information représentative de l'absence ou de la présence d'un phénomène de *quench* dans le lien supraconducteur 104. Cette information, présente sous la forme d'un signal contenant une composante continue d'intérêt et une composante présentant une fréquence de deux fois la fréquence des grandeurs du lien d'alimentation 104, est ensuite filtrée par un circuit filtre passe-bas 4087 à fréquence de coupure contrôlée pour obtenir une autre information, encore plus fiable, car dépourvue de perturbations de hautes fréquences, représentative de l'absence ou de la présence d'un phénomène de *quench* dans le lien d'alimentation supraconducteur 104. Le circuit filtre passe-bas 4087 comprend une entrée de contrôle de fréquence de coupure 4082b, laquelle entrée 4082b est connectée à une sortie 4082a du module de détermination de fréquence 4080s. Il est ainsi avantageusement possible d'opérer un filtrage de type « passe-bas » ajusté et dont la fréquence de coupure dépend de la fréquence de rotation du rotor du moteur électrique 100. Des perturbations de mesures inhérentes au fait que la composante inductive des grandeurs en présence est généralement bien supérieure à la composante résistive de ces mêmes grandeurs sont donc évitées. Le signal filtré par le circuit filtre passe-bas 4087 disponible en sortie de ce dernier est ensuite appliqué, via un lien de connexion 4088 à un circuit de commande 4089 configuré pour inhiber la sortie CTRL de contrôle de courant de l'onduleur 102 en présence d'un problème tel que par exemple un phénomène de *quench.* Le circuit de commande 4089 est configuré pour détecter un phénomène de *quench,* tel que cela est précédemment décrit, et peut être configuré en outre pour détecter un problème de température ou encore un problème de courant, par exemple. Plus largement, le circuit de commande 4089 est configuré pour opérer des fonctions de supervision et de protection du circuit d'alimentation électrique supraconducteur. En effet, un signal disponible à la sortie 407f du circuit de commande 4089 est appliqué à une sortie de commande (ou sortie commandée) configurée pour valider ou inhiber la transmission d'un signal de commande 407c transmissible vers la broche de sortie CTRL du contrôleur 106 de circuit d'alimentation, via un circuit de sortie commandée 407g. Ainsi, le signal de commande 407c transmissible vers la broche de sortie CTRL est déterminé à titre d'exemple par une commande vectorielle. Le signal 107 est donc identique au signal 407c lorsque le circuit de sortie commandée 407g n'est pas activé par le circuit de commande 4089 pour inhiber la commande en courant de l'onduleur 102. Un circuit 4070 de contrôle du couple moteur détermine un signal de commande CTRL à partir d'un signal 4084 qui correspond à la consigne de couple et du signal 4081c représentatif de la position angulaire du moteur électrique 100. Le signal 4084 représentatif de la consigne de couple est délivré par un circuit de régulation de vitesse 4083 qui opère à partir du module 4080s de détermination de la fréquence de rotation du moteur électrique 100.

La **Fig. 6** illustre un aéronef 1 comprenant le système d'alimentation électrique 10 précédemment décrit, lequel système comprend le contrôleur 106. L'utilisation d'un tel système à bord d'un aéronef propulsé à l'aide d'au moins un moteur électrique tel que le moteur électrique 100 permet d'offrir un niveau de sécurité accru en cas d'apparition de phénomène de *quench* sur un lien d'alimentation électrique d'un moteur.

L'utilisation astucieuse d'une mesure de positionnement θ du rotor du moteur électrique permet avantageusement de s'affranchir de l'utilisation d'un circuit PLL (circuit à boucle à verrouillage de phase) pour opérer une discrimination entre la composante résistive et la composante inductive des grandeurs électriques en présence. En effet, l'utilisation d'un circuit PLL est complexe et sensible dans un environnement bruité tel qu'un lien d'alimentation électrique d'un moteur électrique.

En outre, l'utilisation astucieuse d'un circuit filtre passe-bas à fréquence de coupure contrôlée en fonction de la fréquence de rotation du moteur permet d'obtenir un compromis entre la bande passante des signaux pour laquelle une protection est implémentée et la réjection des signaux parasites de plus haute-fréquence, notamment la composante à une fréquence double de la fréquence de travail inhérente à la multiplication réalisée par le module ou circuit multiplieur.

Enfin, une implémentation selon les modes de réalisation décrits permet avantageusement d'accroître sensiblement le niveau de sécurité tout en étant simple et avec un supplément très limité de ressources matérielles.

## Revendications

1. Procédé de contrôle d'un circuit d'alimentation (102, 104) d'un moteur électrique (100), le circuit d'alimentation (102, 104) comprenant un convertisseur de puissance (102) dit onduleur (102) configuré pour délivrer au moins une tension alternative à partir d'une source de tension continue (101) et un lien d'alimentation supraconducteur (104) configuré pour alimenter ledit moteur électrique (100), le lien d'alimentation supraconducteur (104) étant connecté entre une sortie de l'onduleur (102) et le moteur électrique (100), ledit procédé exécuté dans un contrôleur (106) de circuit d'alimentation comprenant une sortie de contrôle (CTRL) configurée pour contrôler ledit onduleur (102), au moins une première entrée (Vi) configurée pour recevoir au moins un premier signal représentatif d'une tension mesurée aux bornes dudit lien d'alimentation supraconducteur (104), et une deuxième entrée (θ), dite de synchronisation, configurée pour recevoir au moins un deuxième signal représentatif de la position d'un rotor dudit moteur électrique (100), ledit procédé étant **caractérisé en ce qu'**il comprend :
- i) multiplier ledit premier signal et un signal sinusoïdal synchronisé avec ledit deuxième signal pour obtenir un troisième signal représentatif de la composante résistive de ladite tension mesurée aux bornes dudit lien d'alimentation supraconducteur (104), puis,
- ii) si ledit troisième signal excède une valeur seuil prédéterminée, inhiber ladite sortie de contrôle (CTRL), et sinon, réitérer les étapes i) et ii).

2. Procédé de contrôle d'un circuit d'alimentation (102, 104) selon la revendication 1, dans lequel obtenir ledit troisième signal comprend un filtrage passe-bas d'un résultat de multiplication dudit premier signal avec ledit deuxième signal.

3. Dispositif contrôleur (106) de circuit d'alimentation (102, 104) d'un moteur électrique (100), ledit circuit d'alimentation (102, 104) comprenant un convertisseur de puissance (102), dit onduleur (102), configuré pour délivrer au moins une tension alternative à partir d'une source de tension continue (101) et un lien d'alimentation supraconducteur (104) configuré pour alimenter ledit moteur électrique (100), le lien d'alimentation supraconducteur (104) étant connecté entre une sortie de l'onduleur (102) et le moteur électrique (100), ledit dispositif contrôleur (106) de circuit d'alimentation comprenant une sortie de contrôle (CTRL) configurée pour contrôler ledit onduleur (102), au moins une première entrée (Vi) configurée pour recevoir au moins un premier signal représentatif d'une tension mesurée aux bornes dudit lien d'alimentation supraconducteur (104), et une deuxième entrée (θ), dite de synchronisation configurée pour recevoir au moins un deuxième signal représentatif de la position d'un rotor dudit moteur électrique (100), ledit dispositif contrôleur (106) de circuit d'alimentation étant **caractérisé en ce qu'**il comprend de la circuiterie électronique configurée pour :
- i) multiplier ledit premier signal et un signal sinusoïdal synchronisé avec ledit deuxième signal pour obtenir un troisième signal représentatif de la composante résistive de ladite tension mesurée aux bornes dudit lien d'alimentation supraconducteur (104), puis,
- ii) si ledit troisième signal excède une valeur seuil, inhiber ladite sortie de contrôle, et sinon, réitérer les étapes i) et ii).

4. Dispositif contrôleur (106) selon la revendication 3 comprenant en outre un circuit de filtrage passe-bas d'un résultat de multiplication dudit premier signal avec ledit deuxième signal pour obtenir ledit troisième signal.

5. Dispositif contrôleur (106) selon la revendication 3, dans lequel ladite circuiterie électronique comprend une unité de contrôle à microprocesseur.

6. Dispositif contrôleur (106) selon l'une des revendications 3 et 4, le dispositif contrôleur (106) comprenant :
- un circuit multiplieur de signaux (4085) comprenant une sortie (4086) et deux entrées (409, 4081b) dont l'une, première (109) desdites deux entrées, est connectée à ladite première entrée (Vi) et l'autre, deuxième (4081b) desdites deux entrées, est connectée à une sortie d'un générateur de signaux sinusoïdaux contrôlés (4080g),
- un circuit filtre passe-bas (4087) à fréquence de coupure contrôlée, comprenant une sortie (4088) de signal filtré et une entrée de signal à filtrer, laquelle entrée est connectée à ladite sortie (4086) dudit multiplieur de signaux (4085), et une entrée de contrôle de fréquence de coupure (4082b), laquelle entrée est connectée à une sortie (4082a) d'un module de détermination de fréquence (4080s),
- un circuit de commande (4089) comprenant une entrée (4088) connectée à ladite sortie (4088) dudit circuit filtre passe-bas (4087), et une sortie de commande (407f, 407g) configurée pour valider ou inhiber la transmission d'un signal de commande (407c) transmissible vers ladite sortie de contrôle (CTRL).

7. Dispositif contrôleur (106) selon la revendication précédente, dans lequel ledit module de détermination de fréquence (4080s) est configuré pour déterminer une fréquence de rotation dudit moteur électrique à partir d'un signal électrique (408) comprenant des impulsions, appliqué sur ladite deuxième entrée (θ) et ledit générateur de signaux sinusoïdaux contrôlés (4080g) est configuré pour générer un signal sinusoïdal de fréquence déterminée synchronisé avec une position de référence du rotor du moteur électrique (100).

8. Dispositif contrôleur (106) selon la revendication 7, dans lequel ladite fréquence de coupure contrôlée dudit filtre passe-bas (1087) est déterminée grâce à ladite fréquence de rotation déterminée.

9. Système d'alimentation électrique (10) d'un moteur électrique (100) comprenant un dispositif contrôleur (106) de circuit d'alimentation (102, 104) d'un moteur électrique (100) l'une des revendications 3 à 8.

10. Aéronef (3) comprenant au moins un dispositif contrôleur (106) de circuit d'alimentation (102, 104) d'un moteur électrique (100) selon l'une des revendications 3 à 8.

11. Aéronef (3) comprenant au moins un système d'alimentation électrique (10) d'un moteur électrique (100) selon la revendication 9.

12. Produit programme d'ordinateur comprenant des instructions de codes de programme pour exécuter les étapes du procédé selon l'une des revendications 1 ou 2, lorsque ledit programme est exécuté par un processeur d'un contrôleur de circuit d'alimentation.

13. Support de stockage comprenant un produit programme d'ordinateur selon la revendication précédente.

## Patentansprüche

1. Verfahren zur Steuerung einer Versorgungsschaltung (102, 104) eines Elektromotors (100), wobei die Versorgungsschaltung (102, 104) einen Leistungsumformer (102), Wechselrichter (102) genannt, der dazu ausgestaltet ist, mindestens eine Wechselspannung ausgehend von einer Gleichspannungsquelle (101) abzugeben, und eine supraleitende Versorgungsleitung (104), die dazu ausgestaltet ist, den Elektromotor (100) zu versorgen, umfasst, wobei die supraleitende Versorgungsleitung (104) zwischen einem Ausgang des Wechselrichters (102) und dem Elektromotor (100) angeschlossen ist, wobei das Verfahren in einer Steuerung (106) einer Versorgungsschaltung ausgeführt wird, die einen Steuerungsausgang (CTRL), der dazu ausgestaltet ist, den Wechselrichter (102) zu steuern, mindestens einen ersten Eingang (Vi), der dazu ausgestaltet ist, mindestens ein erstes Signal zu empfangen, das für eine an den Klemmen der supraleitenden Versorgungsleitung (104) gemessene Spannung repräsentativ ist, und einen zweiten Eingang (θ), Synchronisationseingang genannt, der dazu ausgestaltet ist, mindestens ein zweites Signal zu empfangen, das für die Position eines Rotors des Elektromotors (100) repräsentativ ist, umfasst, wobei das Verfahren **dadurch gekennzeichnet ist, dass** es umfasst:
- i) Multiplizieren des ersten Signals und eines sinusförmigen Signals, das mit dem zweiten Signal synchronisiert ist, um ein drittes Signal zu erhalten, das für die resistive Komponente der an den Klemmen der supraleitenden Versorgungsleitung (104) gemessenen Spannung repräsentativ ist, dann,
- ii) wenn das dritte Signal einen vorbestimmten Schwellenwert überschreitet, Sperren des Steuerungsausgangs (CTRL), und ansonsten Wiederholen der Schritte i) und ii).

2. Verfahren zur Steuerung einer Versorgungsschaltung (102, 104) nach Anspruch 1, bei dem das Erhalten des dritten Signals eine Tiefpassfilterung eines Ergebnisses einer Multiplikation des ersten Signals mit dem zweiten Signal umfasst.

3. Steuerungsvorrichtung (106) für eine Versorgungsschaltung (102, 104) eines Elektromotors (100), wobei die Versorgungsschaltung (102, 104) einen Leistungsumformer (102), Wechselrichter (102) genannt, der dazu ausgestaltet ist, mindestens eine Wechselspannung ausgehend von einer Gleichspannungsquelle (101) abzugeben, und eine supraleitende Versorgungsleitung (104), die dazu ausgestaltet ist, den Elektromotor (100) zu versorgen, umfasst, wobei die supraleitende Versorgungsleitung (104) zwischen einem Ausgang des Wechselrichters (102) und dem Elektromotor (100) angeschlossen ist, wobei die Steuerungsvorrichtung (106) für eine Versorgungsschaltung einen Steuerungsausgang (CTRL), der dazu ausgestaltet ist, den Wechselrichter (102) zu steuern, mindestens einen ersten Eingang (Vi), der dazu ausgestaltet ist, mindestens ein erstes Signal zu empfangen, das für eine an den Klemmen der supraleitenden Versorgungsleitung (104) gemessene Spannung repräsentativ ist, und einen zweiten Eingang (θ), Synchronisationseingang genannt, der dazu ausgestaltet ist, mindestens ein zweites Signal zu empfangen, das für die Position eines Rotors des Elektromotors (100) repräsentativ ist, umfasst, wobei die Steuerungsvorrichtung (106) für eine Versorgungsschaltung **dadurch gekennzeichnet ist, dass** sie eine elektronische Schaltungsanordnung umfasst zum:
- i) Multiplizieren des ersten Signals und eines sinusförmigen Signals, das mit dem zweiten Signal synchronisiert ist, um ein drittes Signal zu erhalten, das für die resistive Komponente der an den Klemmen der supraleitenden Versorgungsleitung (104) gemessenen Spannung repräsentativ ist, dann,
- ii) wenn das dritte Signal einen Schwellenwert überschreitet, Sperren des Steuerungsausgangs, und ansonsten Wiederholen der Schritte i) und ii).

4. Steuerungsvorrichtung (106) nach Anspruch 3, die ferner eine Schaltung zur Tiefpassfilterung eines Ergebnisses einer Multiplikation des ersten Signals mit dem zweiten Signal, um das dritte Signal zu erhalten, umfasst.

5. Steuerungsvorrichtung (106) nach Anspruch 3, bei der die elektronische Schaltungsanordnung eine Steuerungseinheit mit Mikroprozessor umfasst.

6. Steuerungsvorrichtung (106) nach einem der Ansprüche 3 und 4, wobei die Steuerungsvorrichtung (106) umfasst:
- eine Signalmultipliziererschaltung (4085), die einen Ausgang (4086) und zwei Eingänge (409, 4081b) umfasst, von denen der eine, erster (109) der beiden Eingänge, an den ersten Eingang (Vi) angeschlossen ist, und der andere, zweiter (4081b) der beiden Eingänge, an einen Ausgang eines Generators für gesteuerte sinusförmige Signale (4080g) angeschlossen ist,
- eine Tiefpassfilterschaltung (4087) mit gesteuerter Grenzfrequenz, umfassend einen Ausgang (4088) für ein gefiltertes Signal und einen Eingang für ein zu filterndes Signal, wobei der Eingang an den Ausgang (4086) des Signalmultiplizierers (4085) angeschlossen ist, und einen Grenzfrequenzsteuerungseingang (4082b), wobei der Eingang an einen Ausgang (4082a) eines Frequenzbestimmungsmoduls (4080s) angeschlossen ist,
- eine Steuerschaltung (4089), umfassend einen Eingang (4088), der an den Ausgang (4088) der Tiefpassfilterschaltung (4087) angeschlossen ist, und einen Steuerausgang (407f, 407g), der dazu ausgestaltet ist, die Übertragung eines zu dem Steuerungsausgang (CTRL) übertragbaren Steuersignals (407c) zu validieren oder zu sperren.

7. Steuerungsvorrichtung (106) nach dem vorhergehenden Anspruch, bei der das Frequenzbestimmungsmodul (4080s) dazu ausgestaltet ist, eine Rotationsfrequenz des Elektromotors ausgehend von einem Impulse umfassenden elektrischen Signal (408) zu bestimmen, das an den zweiten Eingang (θ) angelegt wird, und der Generator für gesteuerte sinusförmige Signale (4080g) dazu ausgestaltet ist, ein sinusförmiges Signal mit einer bestimmten Frequenz zu erzeugen, das mit einer Referenzposition des Elektromotors (100) synchronisiert ist.

8. Steuerungsvorrichtung (106) nach Anspruch 7, bei der die gesteuerte Grenzfrequenz des Tiefpassfilters (1087) dank der bestimmten Rotationsfrequenz bestimmt wird.

9. Stromversorgungssystem (10) eines Elektromotors (100), das eine Steuerungsvorrichtung (106) für eine Versorgungsschaltung (102, 104) eines Elektromotors (100) nach einem der Ansprüche 3 bis 8 umfasst.

10. Luftfahrzeug (3), das eine Steuerungsvorrichtung (106) für eine Versorgungsschaltung (102, 104) eines Elektromotors (100) nach einem der Ansprüche 3 bis 8 umfasst.

11. Luftfahrzeug (3), das mindestens ein Stromversorgungssystem (10) eines Elektromotors (100) nach Anspruch 9 umfasst.

12. Computerprogrammprodukt, das Programmcodeanweisungen umfasst, die bei der Ausführung des Programms durch einen Prozessor einer Versorgungsschaltungssteuerung die Schritte des Verfahrens nach einem der Ansprüche 1 oder 2 ausführen.

13. Speichermedium, das ein Computerprogrammprodukt nach dem vorhergehenden Anspruch umfasst.

## Claims

1. Method for controlling a power supply circuit (102, 104) of an electric motor (100), the power supply circuit (102, 104) comprising a power converter (102), referred to as an inverter (102), which is configured to supply at least one AC voltage from a DC voltage source (101) and a superconducting power supply link (104), which is configured to supply said electric motor (100) with power, the superconducting power supply link (104) being connected between an output of the inverter (102) and the electric motor (100), said method being executed in a power supply circuit controller (106) comprising a control output (CTRL) configured to control said inverter (102), at least one first input (Vi) configured to receive at least one first signal representative of a voltage measured across the terminals of said superconducting power supply link (104), and a second input (θ), referred to as a synchronization input, configured to receive at least one second signal representative of the position of a rotor of said electric motor (100), said method being **characterized in that** it comprises:
- i) multiplying said first signal and a sinusoidal signal synchronized with said second signal to obtain a third signal that is representative of the resistive component of said voltage measured across the terminals of said superconducting power supply link (104), and then,
- ii) if said third signal exceeds a predetermined threshold value, inhibiting said control output (CTRL), and if not, repeating steps i) and ii).

2. Method for controlling a power supply circuit (102, 104) according to Claim 1, wherein obtaining said third signal comprises low-pass filtering a result of the multiplication of said first signal with said second signal.

3. Controller device (106) for a power supply circuit (102, 104) of an electric motor (100), said power supply circuit (102, 104) comprising a power converter (102), referred to as an inverter (102), which is configured to supply at least one AC voltage from a DC voltage source (101) and a superconducting power supply link (104), which is configured to supply said electric motor (100) with power, the superconducting power supply link (104) being connected between an output of the inverter (102) and the electric motor (100), said controller device (106) for a power supply circuit comprising a control output (CTRL) configured to control said inverter (102), at least one first input (Vi) configured to receive at least one first signal representative of a voltage measured across the terminals of said superconducting power supply link (104), and a second input (θ), referred to as a synchronization input, configured to receive at least one second signal representative of the position of a rotor of said electric motor (100), said controller device (106) for a power supply circuit being **characterized in that** it comprises electronic circuitry that is configured to:
- i) multiply said first signal and a sinusoidal signal synchronized with said second signal to obtain a third signal that is representative of the resistive component of said voltage measured across the terminals of said superconducting power supply link (104), and then,
- ii) if said third signal exceeds a threshold value, inhibit said control output, and if not, repeat steps i) and ii).

4. Controller device (106) according to Claim 3, further comprising a circuit for low-pass filtering a result of the multiplication of said first signal with said second signal to obtain said third signal.

5. Controller device (106) according to Claim 3, wherein said electronic circuitry comprises a microprocessor-based control unit.

6. Controller device (106) according to either of Claims 3 and 4, the controller device (106) comprising:
- a signal multiplier circuit (4085) comprising an output (4086) and two inputs (409, 4081b), one of which, the first (109) of said two inputs, is connected to said first input (Vi) and the other of which, the second (4081b) of said two inputs, is connected to an output of a controlled sinusoidal signal generator (4080g),
- a low-pass filter circuit (4087) with a controlled cut-off frequency, comprising a filtered signal output (4088) and an input for a signal to be filtered, which input is connected to said output (4086) of said signal multiplier (4085), and a cut-off frequency control input (4082b), which input is connected to an output (4082a) of a frequency determination module (4080s),
- a command circuit (4089) comprising an input (4088) connected to said output (4088) of said low-pass filter circuit (4087), and a command output (407f, 407g) that is configured to validate or inhibit the transmission of a command signal (407c) that is able to be transmitted to said control output (CTRL).

7. Controller device (106) according to the preceding claim, wherein said frequency determination module (4080s) is configured to determine a frequency of rotation of said electric motor from an electrical signal (408), comprising pulses, that is applied to said second input (θ) and said controlled sinusoidal signal generator (4080g) is configured to generate a sinusoidal signal of determined frequency that is synchronized with a reference position of the rotor of the electric motor (100).

8. Controller device (106) according to Claim 7, wherein said controlled cut-off frequency of said low-pass filter (1087) is determined by way of said determined frequency of rotation.

9. System (10) for supplying electrical power to an electric motor (100), comprising a controller device (106) for a power supply circuit (102, 104) of an electric motor (100) according to one of Claims 3 to 8.

10. Aircraft (3) comprising at least one controller device (106) for a power supply circuit (102, 104) of an electric motor (100) according to one of Claims 3 to 8.

11. Aircraft (3) comprising at least one system (10) for supplying electrical power to an electric motor (100) according to Claim 9.

12. Computer program product comprising program code instructions for executing the steps of the method according to either of Claims 1 and 2, when said program is executed by a processor of a power supply circuit controller.

13. Storage medium comprising a computer program product according to the preceding claim.
